Europäisches Patentamt

European Patent Office

Office européen des brevets

(19)

(11) Numéro de publication: **0 242 933 B1**

(12) **FASCICULE DE BREVET EUROPEEN**

(45) Date de publication de fascicule du brevet:
**25.09.91**

(21) Numéro de dépôt: **87200973.3**

(22) Date de dépôt: **23.01.87**

(51) Int. Cl.⁵: $G02F\ 1/133$

(60) Numéro de publication de la demande initiale
en application de l'article 76 CBE : **0 236 169**

(54) Ecran d'affichage à matrice active sans transistor parasite et prcoédé de fabrication de cet écran.

(30) Priorité: **27.01.86 FR 8601083**

(43) Date de publication de la demande:
**28.10.87 Bulletin 87/44**

(45) Mention de la délivrance du brevet:
**25.09.91 Bulletin 91/39**

(84) Etats contractants désignés:
**CH DE GB IT LI NL SE**

(56) Documents cités:
**EP-A- 0 103 523**

**PATENT ABSTRACTS OF JAPAN, vol. 10, no. 32 (E-379)[2089], 7 février 1986; & JP-A-60 189 969**

(73) Titulaire: **Maurice, François**
**125 Boulevard de la Corniche**
**F-22700 Perros-Guirec(FR)**

Titulaire: **Richard, Joseph**
**33 Lotissement Keranroux Ploubezre**
**F-22300 Lannion(FR)**

Titulaire: **Vinouze, Bruno**
**3, Chemin de la Chapelle Port Blanc**
**F-22710 Penvenan(FR)**

(72) Inventeur: **Maurice, François**
**125 Boulevard de la Corniche**
**F-22700 Perros-Guirec(FR)**
Inventeur: **Richard, Joseph**
**33 Lotissement Keranroux Ploubezre**
**F-22300 Lannion(FR)**
Inventeur: **Vinouze, Bruno**
**3, Chemin de la Chapelle Port Blanc**
**F-22710 Penvenan(FR)**

(74) Mandataire: **Mongrédien, André et al**
**c/o BREVATOME 25, rue de Ponthieu**
**F-75008 Paris(FR)**

## Description

La présente invention a pour objet un écran d'affichage à matrice active sans transistor parasite et un procédé de fabrication de cet écran.

Un écran d'affichage à matrice active comprend généralement deux plaques entre lesquelles est intercalé un matériau électrooptique comme un cristal liquide. Sur l'une des plaques, on trouve une matrice de pavés conducteurs transparents, des transistors en couches minces, une famille de lignes conductrices d'adressage et une famille de colonnes conductrices d'adressage. Chaque transistor possède une grille reliée à une ligne, une source reliée à un pavé et un drain relié à une colonne. Sur la seconde plaque, on trouve une contre-électrode.

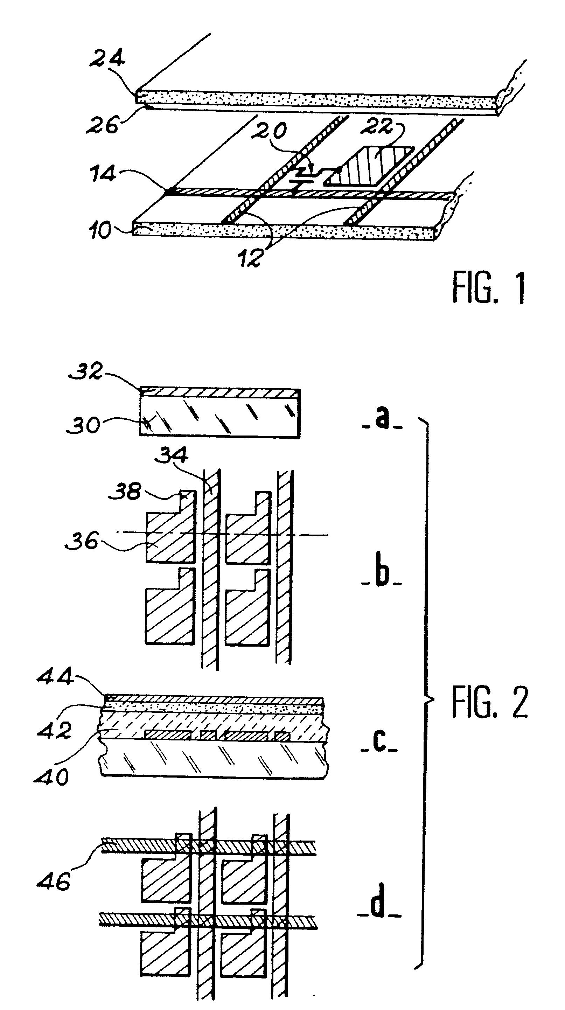

Une telle structure est représentée sur la figure 1. On y a représenté de manière simplifiée une plaque inférieure 10 portant des colonnes conductrices 12, des lignes conductrices 14, des transistors 20 et des pavés conducteurs 22, et une plaque supérieure 24 recouverte d'une contre-électrode 26.

Pour obtenir une telle structure, on peut mettre en oeuvre un procédé dont les principales étapes sont illustrées sur la figure 2. Ce procédé comprend les opérations suivantes :
- préparation d'un substrat de verre 30 par nettoyage physico-chimique,
- dépôt d'une couche 32 de matériau conducteur transparent, par exemple en oxyde d'étain et d'indium (ITO) (partie a),
- première photogravure, pour donner à la couche 32 la forme de colonnes 34 et de pavés 36 munis d'un appendice rectangulaire 38 (partie b),
- dépôts d'une couche de silicium amorphe hydrogéné 40, d'une couche de silice 42 et d'une couche d'aluminium 44, chaque dépôt étant effectué à environ 250°C (ou plus si on utilise la technique de CVD-plasma) (partie c),
- seconde photogravure, pour définir des lignes 46 chevauchant les appendices 38 et croisant les colonnes, ce qui définit les transistors (partie d),
- passivation générale par dépôt d'une couche de SiO₂ (non représentée).

Un tel procédé, à deux niveaux de masquage, est décrit dans la demande de brevet français FR-A-2 533 072.

Malgré sa simplicité, ce procédé présente un inconvénient car il crée un transistor parasite entre le transistor principal et la colonne qui suit.

Le but de l'invention est justement de remédier à cet inconvénient. A cette fin, l'invention préconise l'utilisation d'un appendice de drain de forme telle que ce transistor parasite soit supprimé.

La présente invention a également pour objet un procédé de fabrication d'un tel écran.

De toutes façons, les caractéristiques de l'invention apparaîtront mieux à la lecture de la description qui va suivre, d'exemples de réalisation donnés à titre explicatif et nullement limitatif. Cette description se réfère à des dessins annexés sur lesquels :
- la figure 1, déjà décrite, montre la structure d'un écran d'affichage à matrice active selon l'art antérieur,
- la figure 2, déjà décrite, illustre un procédé de fabrication connu utilisé pour fabriquer un écran d'affichage à matrice active,
- la figure 3 illustre un procédé de réalisation de l'écran d'affichage de l'invention, utilisant seulement deux niveaux de masquage et évitant l'apparition de transistor parasite.

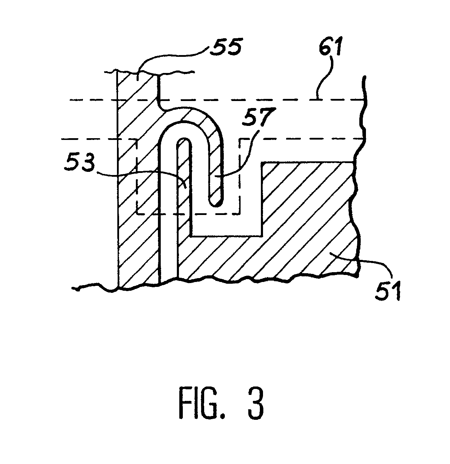

La figure 3 illustre un procédé de réalisation d'un écran d'affichage selon l'invention. Les opérations à accomplir commencent par un dépôt, sur un substrat isolant, d'une couche d'un conducteur transparent, ITO par exemple, surmontée d'une couche de silicium amorphe dopé n. Puis est effectuée une première photogravure pour former des pavés 51, avec un appendice 53, des colonnes 55 avec un appendice 57 (en trait plein sur la figure 3). Est déposé ensuite un empilement constitué par une couche de silicium amorphe hydrogéné, une couche d'un premier isolant et une couche métallique. Cet empilement fait l'objet d'une seconde photogravure pour laisser subsister des lignes 61 et une grille au-dessus des deux appendices 53, 57 (en tirets sur la figure 3).

Grâce à la forme particulière donnée à l'appendice 57, on a éliminé le transistor parasite qui existait entre l'appendice 53 et la colonne suivante.

## Revendications

1. Ecran d'affichage à matrice active comprenant une première paroi (10) revêtue
   - d'une matrice de pavés conducteurs, chaque pavé (51 ; 22) étant relié à un premier appendice (53 ; 38),
   - de transistors en couches minces (20),
   - d'une famille de lignes conductrices d'adressage (61 ; 14) et
   - d'une famille de colonnes conductrices d'adressage (55 ; 12)
   
   chaque transistor ayant la grille reliée à une des lignes, la source formée par ledit premier appendice (53 ; 38) correspondant et le drain relié à une des colonnes (55 ; 12),
   
   cet écran comportant encore une seconde paroi (24) portant une contre-électrode (26) et un matériau électro-optique inséré entre les deux parois, cet écran étant

caractérisé en ce que

- chaque transistor de chaque colonne (55) a un second appendice (57) constituant le drain du dit transistor et en ce que
- la colonne (55) et le second appendice (57) enferment l'appendice (53) du pavé (51) sur trois côtés, de sorte que le transistor parasite entre l'appendice (53) du pavé et la colonne suivante se trouve éliminé.

2. Procédé de fabrication d'un écran d'affichage à matrice active selon la revendication 1, ce procédé consistant à réaliser une paroi inférieure (10) portant des premières armatures (22) de condensateurs et des transistors à couches minces (20), des lignes (14) et des colonnes (12) conductrices d'adressage, et une paroi supérieure (24) revêtue d'une contre-électrode (20) formant seconde armature des condensateurs, ce procédé comprenant, pour réaliser la paroi inférieure (10) les opérations suivantes :

- dépôt sur un substrat isolant (50) d'une couche d'un premier matériau conducteur transparent (52),
- première photogravure pour constituer des pavés (51) formant des armatures des futurs condensateurs, des colonnes (55) et des appendices (53) constituant les futures sources des transistors et reliés aux pavés (51),
- dépôt d'un empilement constitué par une couche de silicium amorphe hydrogéné (60), d'une couche d'un premier isolant (62) et d'une couche métallique (66),
- seconde photogravure appliquée à l'empilement précédent pour laisser subsister des lignes (61) et des grilles au-dessus de l'appendice (53),

ce procédé étant caractérisé par le fait que, lors de la première photogravure, on forme des seconds appendices (57) constituant les futurs drains des transistors, ces seconds appendices (57) étant reliés aux colonnes (55), chaque colonne (55) et le second appendice y relié (57) enfermant l'appendice (53) du pavé (51) sur trois côtés, de sorte que le transistor parasite entre l'appendice (53) du pavé et la colonne suivante se trouve éliminé.

**Claims**

1. Active matrix display screen comprising a first wall (10) coated by a matrix of conductive blocks, each block (51; 22) being connected to a first appendix (53; 38), thin film transistors (20), a plurality of conductive addressing lines (61; 14) and a plurality of conductive addressing columns (55; 12), each transistor having a gate connected to one of the lines of the source formed by said first appendix (53; 38) corresponding thereto and the drain connected to one of the columns (55; 12), said screen also having a second wall (24) carrying a counterelectrode (26) and an electrooptical material inserted between the two walls, the screen being characterized in that each transistor of each column (55) has a second appendix (57) constituting the drain of said transistor and in that the column (55) and the second appendix (57) surround the appendix (53) of the block (51) on three sides, so that the parasitic transistor between the block appendix (53) and the following column is eliminated.

2. Process for the production of an active matrix display screen according to claim 1, said process consisting of producing a lower wall (10) carrying first capacitor plates (22) and thin film transistors (20), conductive addressing columns (12) and lines (14), and an upper wall (24) covered by a counterelectrode (20) forming the second capacitor plate, said process comprising, for producing the lower wall (10), the following operations:

deposition on an insulating substrate (50) of a layer of a first transparent conductive material (52),

first photoetching for forming blocks (51) forming plates of future capacitors, columns (55) and appendices (53) constituting the future sources of the transistors and connected to the blocks (51),

deposition of a stack constituted by a hydrogenated amorphous silicon layer (60), a first insulant layer (62) and a metal layer (66),

second photoetching applied to the preceding stack to leave behind lines (61) and gates above the appendix (53),

said process being characterized in that, during the first photoetching, formation takes place of second appendices (57) constituting the future drains of the transistors, said appendices (57) being connected to the columns (55), each column (55) and the second appendix (57) connected thereto surrounding the appendix (53) of the block (51) on three sides, so that the parasitic transistor between the block appendix (53) and the following column is eliminated.

**Patentansprüche**

1. Anzeigebildschirm mit aktiver Matrix mit einer ersten Seitenwand (10), die überdeckt ist von:

   einer Matrix von leitenden Plättchen oder Flekken, wobei jedes Plättchen (51;22) mit einem ersten Ansatzstück (53;38) verbunden ist,

   Dünnschichttransistoren (20),

   einer Gruppe von leitenden Adreßzeilen (61;14) und

   einer Gruppe von leitenden Adreßspalten (55; 12),

   wobei jeder Transistor das Gitter verbunden hat mit einer der Zeilen, die Quelle durch das erste Ansatzstück (53;38) entsprechend gebildet wird, und der Drain verbunden ist mit einer der Spalten (55;12),

   wobei der Bildschirm weiterhin eine zweite Seitenwand (24) aufweist, die eine Gegenelektrode (26) trägt, und ein elektrooptisches Material zwischen die beiden Seitenwände eingebracht ist, wobei der Bildschirm dadurch gekennzeichnet ist, daß

   ein jeder Transistor einer jeden Spalte (55) ein zweites Ansatzstück (57) hat, das den Drain des Transistors bildet, und

   daß die Spalte (55) und das zweite Ansatzstück (57), das Ansatzstück (53) des Plättchens (51) an drei Seiten einschließt, derart, daß der parasitäre oder Störtransistor zwischen dem Ansatzstück (53) des Plättchens und der darauffolgenden Spalte eleminiert wird.

2. Verfahren zum Herstellen eines Anzeigebildschirms mit aktiver Matrix nach Anspuch 1, wobei das Verfahren besteht aus Herstellen einer unteren Seitenwand (10), die erste Armaturen (22) von Kondensatoren und Dünnschichttransistoren (20), leitende Adreßzeilen (14) und leitende Adreßspalten (12) trägt, und eine obere Seitenwand (24) trägt, die von einer Gegenelektrode (20) überdeckt ist, die die zweite Armatur der Kondensatoren bildet, wobei das Verfahren zur Herstellung der unteren Seitenwand (10) die folgenden Schritte aufweist:

   Ablegen auf einem Isolatorsubstrat (50) einer Schicht eines ersten leitenden durchsichtigen Materials (52),

   erste Fotoätzung, um Plättchen (51) zu bilden, die die Armaturen der zukünftigen Kondensatoren bilden, wobei Spalten (55) und Ansatzstükke (53) die zukünftigen Quellen der Transistoren bilden und mit den Plättchen (51) verbunden sind,

   Ablegen einer Schichtung, gebildet aus einer Schicht von amorphem wasserangereichertem Silicium (60), einer Schicht aus einem ersten Isolator (62) und einer metallischen Schicht (66),

   zweite Fotoätzung, angewandt auf die vorhergehende Schichtung, um Zeilen (61) und Gitter oberhalb der Ansatztücke (53) zurückzulassen,

   wobei das Verfahren dadurch gekennzeichnet ist, daß bei einer ersten Fotoätzung zweite Ansatzstücke (57) gebildet werden, die die zukünftigen Drains der Transistoren bilden, wobei die zweiten Ansatzstücke (57) mit den Spalten (55) verbunden werden, wobei jede Spalte (55) und das zweite Ansatzstück, das hiermit verbunden ist (57), das Ansatzstück (53) des Plättchens (51) auf drei Seiten einschließt, derart, daß der Störtransistor zwischen dem Ansatzstück (53) des Plättchens und der nachfolgenden Spalte ausgeschaltet wird.

FIG. 1

FIG. 2

FIG. 3